(19) Europäisches Patentamt
European Patent Office
Office européen des brevets

(11) **EP 1 774 651 B1**

(12) **FASCICULE DE BREVET EUROPEEN**

(45) Date de publication et mention
de la délivrance du brevet:
**14.11.2007 Bulletin 2007/46**

(51) Int Cl.:
**H03H 9/46** *(2006.01)*

(21) Numéro de dépôt: **05782181.1**

(22) Date de dépôt: **29.06.2005**

(86) Numéro de dépôt international:
**PCT/FR2005/050520**

(87) Numéro de publication internationale:
**WO 2006/013301 (09.02.2006 Gazette 2006/06)**

(54) **MICRORESONATEUR COMPOSITE A FORTE DEFORMATION**

VERBUNDMIKRORESONATOR MIT HOHER DEFORMATION

HIGH-DEFORMATION COMPOSITE MICRORESONATOR

(84) Etats contractants désignés:
**DE GB IT**

(30) Priorité: **01.07.2004 FR 0451398**

(43) Date de publication de la demande:
**18.04.2007 Bulletin 2007/16**

(73) Titulaire: **COMMISSARIAT A L'ENERGIE ATOMIQUE**
**75015 Paris (FR)**

(72) Inventeurs:
• **TRIPARD, Amyot**
**05220 Montetier Les Bains (FR)**
• **BRECHET, Yves**
**F-38000 GRENOBLE (FR)**

(74) Mandataire: **Poulin, Gérard et al**
**Brevatome**
**3, rue du Docteur Lancereaux**
**75008 Paris (FR)**

(56) Documents cités:
**US-A1- 2002 105 393** **US-A1- 2003 168 929**

• **POURKAMALI S ET AL: "SOI-based rf and vhf single-crystal silicon resonators with sub-100 nanometer vertical capacitive gaps" TRANSDUCERS 03. 12TH INTERNATIONAL CONFERENCE ON SOLID-STATE SENSORS, ACTUATORS AND MICROSYSTEMS. DIGEST OF TECHNICAL PAPERS, 9 juin 2003 (2003-06-09), pages 837-840, XP010646838 PISCATAWAY, NJ, USA**
• **NGUYEN C T-C: "Micromechanical circuits for communication transceivers" PROCEEDINGS OF THE 2000 BIPOLAR BICMOS CIRCUITS AND TECHNOLOGY MEETING, 24 septembre 2000 (2000-09-24), pages 142-149, XP010524193 PISCATAWAY, NJ, USA**

## EP 1 774 651 B1

**Description**

## DOMAINE TECHNIQUE ET ART ANTÉRIEUR

L'invention concerne le domaine des micro résonateurs.

Dans le domaine de la téléphonie mobile par exemple, les micro-résonateurs interviennent dans la composition de filtres, de VCO (voltage control oscillator) ainsi que des oscillateurs de référence.

Dans l'optique d'une intégration, on cherche à obtenir des composants de type résonateur présentant de préférence les caractéristiques suivantes :

- faibles dimensions,
- fréquences de résonances variées (de moins de quelques MHz à plus de quelques GHz),
- facteur de qualité élevé,
- faibles pertes de signal (niveau de sortie le plus haut possible), ce qui demande un fort couplage électromécanique,
- une très bonne stabilité en température et en temps,
- compatibilité avec les procédés de la microélectronique.

Parmi le composants conventionnels, deux systèmes sont utilisés pour obtenir une résonance électrique :

- les circuits RLC, qui sont facilement intégrables sur plaquette mais présentent des performances faibles,
- les résonateurs à quartz, qui présentent des performances élevées mais ne peuvent être intégrés dans un procédé de fabrication basé sur la technologie micro système. Ils sont nécessairement usinés séparément puis rapportés. D'où un coût et une taille importants.

Parmi les composants MEMS, on trouve les résonateurs de type SAW (pour « surface acoustique wave », ou « onde acoustique de surface ») : ces composants exploitent la propagation d'ondes de surface dans un matériau piézoélectrique.

Ces ondes sont générées puis détectées par des électrodes en forme de peigne. Les dimensions du composant définissent la fréquence pour laquelle il y a propagation des ondes. Les autres composantes du signal ne sont pas transmises.

Les SAW présentent d'assez bonnes performances. Ils sont cependant de grande taille (1 cm$^2$), ne sont pas intégrables en technologie microélectronique et sont limités en fréquence (dimensions critiques).

On trouve aussi les « FBAR » (pour « film bulk acoustic resonator », résonateur acoustique en film) : il s'agit d'un empilement de type « isolant acoustique-électrode-matériau piézoélectrique-électrode ». Il y a propagation d'ondes acoustiques entre les deux électrodes. La résonance est obtenue lorsque la demi longueur d'onde est égale au chemin acoustique parcouru. Ces composants présentent de bonnes performances mais ne sont pas intégrés à des procédés de microélectronique.

Les composants à résonances électromécaniques utilisent la résonance mécanique d'un élément (poutre en flexion, dilatation d'un cylindre, comme par exemple dans l'article de J.Wang. et al., "1,14 GHZ self-aligned vibrating micromechanical disk resonator" IEEE Radio Frequency Integrated Circuits Symposium (2003)) pour filtrer le signal. Le brevet américain US 2002/105393 divulgue également un résonateur micromécanique.

L'actionnement (et la détection dans le cas où elle est présente) du corps vibrant peuvent être effectués de trois manières :

- à l'aide de matériaux piézoélectriques,
- par l'intermédiaire d'un champ magnétique,
- ou de manière électrostatique (détection capacitive par variation d'entrefer).

Les deux première techniques sont difficilement intégrables actuellement et ne permettent pas d'obtenir des performances très élevées.

Les résonateurs électromécaniques à excitation et détection capacitive sont les plus développés. Ceci s'explique par les performances élevées qui peuvent être obtenues (en termes de facteur de qualité, de fréquence de résonance) mais aussi par la possibilité d'intégration de ces composants dans un procédé de microélectronique.

Cependant, la détection du signal en sortie du composant n'est pas évidente : la littérature mentionne des composants qui n'ont pu être testés.

Ceci est dû aux faibles déplacements obtenus, notamment pour les résonateurs à onde de volume, comme décrit par exemple pour des disques et des plaques dans l'article de V. Kaajakari, T.Mattila, A.Oja, J.Kiihamaki, H.Koskenvuori, P.Rantakari, I.Tittonen, H.Seppa, « Square-extensional mode single-crystal silicon micromechanical RF-resonators », IEEE Transducers 03 (2003).

Le résonateur de l'invention est compatible avec un actionnement (et une détection) piézoélectrique. Pour des raisons d'intégrabilité, on préfère l'actionnement électrostatique.

## EXPOSÉ DE L'INVENTION

L'invention concerne un résonateur électromécanique comportant un corps vibrant, au moins une électrode d'excitation et au moins une électrode de détection, caractérisé en ce que le corps vibrant comporte une première partie en un premier matériau, avec un premier module d'Young, et une deuxième partie, en un deuxième matériau, avec un deuxième module d'Young, inférieur au premier module d'Young, cette deuxième partie étant au moins partiellement située en face de l'électrode de détection.

Le résonateur électromécanique selon l'invention se distingue des résonateurs à onde de volume(disques et plaques principalement) notamment par sa composition et par les déformations qu'il permet d'obtenir.

En effet, le corps vibrant des résonateurs développés par ailleurs est composé d'un unique matériau (disque en silicium, plaque en nickel, etc....). Ce dernier est sélectionné pour ses caractéristiques mécaniques : grande rigidité (module d'Young élevé afin d'augmenter la fréquence de résonance) et faibles pertes d'énergie (par échauffement, perte au niveau des joints de grain, par exemple). En contrepartie, ces matériaux se déforment peu, ce qui rend la détection de la variation d'entrefer difficile.

Le résonateur selon l'invention permet d'obtenir des performances élevées (facteur de qualité, fréquence de résonance entre autres), tout en présentant localement de fortes déformations.

Le premier matériau est de préférence un matériau ayant des caractéristiques mécaniques élevées et assurant les performances du composant, en termes de fréquence de résonance et de facteur de qualité, notamment.

Le deuxième matériau présente une plus faible rigidité (deuxième module d'Young faible, ou inférieur au premier), ce qui lui autorise des déformations importantes et, si possible, de faibles pertes par échauffement.

A titre d'exemples les matériaux suivants peuvent être utilisés :

- premier matériau : silicium monocristallin, nickel ou diamant,
- deuxième matériau : aluminium, ou or, ou Zinc ou Magnésium.

Le corps vibrant peut être par exemple de forme circulaire ou de forme carrée.

Les électrodes peuvent en être disposées à 90° l'une de l'autre.

Un tel résonateur présente de préférence une dimension maximale inférieure à 1 mm, fonction de l'application. Par exemple pour des applications en téléphonie mobile, cette dimension est typiquement inférieure à 50 $\mu$m.

Le deuxième matériau est par exemple présent localement sur une épaisseur e comprise entre 70 % et 100 % de l'épaisseur E du corps vibrant.

Un tel dispositif comporte avantageusement un ancrage ou un pied unique qui le relie à un substrat.

L'invention concerne également un procédé de réalisation d'un résonateur électromécanique, comportant :

- une étape de gravure d'au moins une cavité dans un socle, en un premier matériau, avec un premier module d'Young,
- une étape de dépôt, dans ladite cavité, d'un deuxième matériau, avec un deuxième module d'Young, inférieur au premier module d'Young.

Ce procédé peut en outre comporter une étape de réalisation d'électrodes, en face ou en vis-à-vis du deuxième matériau.

Une étape de gravure permet de libérer le résonateur d'un substrat en ne laissant qu'un pied de liaison à ce substrat.

La ou les cavités peuvent être gravées sur une épaisseur e comprise entre 70 % et 95 % de l'épaisseur E du socle.

## BRÈVE DESCRIPTION DES DESSINS

- Les figures 1A, 1B et 3A, 3B sont des exemples de dispositifs selon l'invention,
- Les figures 2A et 2B illustrent la déformée d'un disque selon un mode spécifique,
- La figure 4 représente la déformée d'un disque composite selon l'invention,
- Les figures 5A-5I représentent des étapes d'un procédé selon l'invention,
- Les figures 6A-6J représentent des étapes d'un autre procédé selon l'invention.

## EXPOSÉ DÉTAILLÉ DE MODES DE RÉALISATION PARTICULIERS

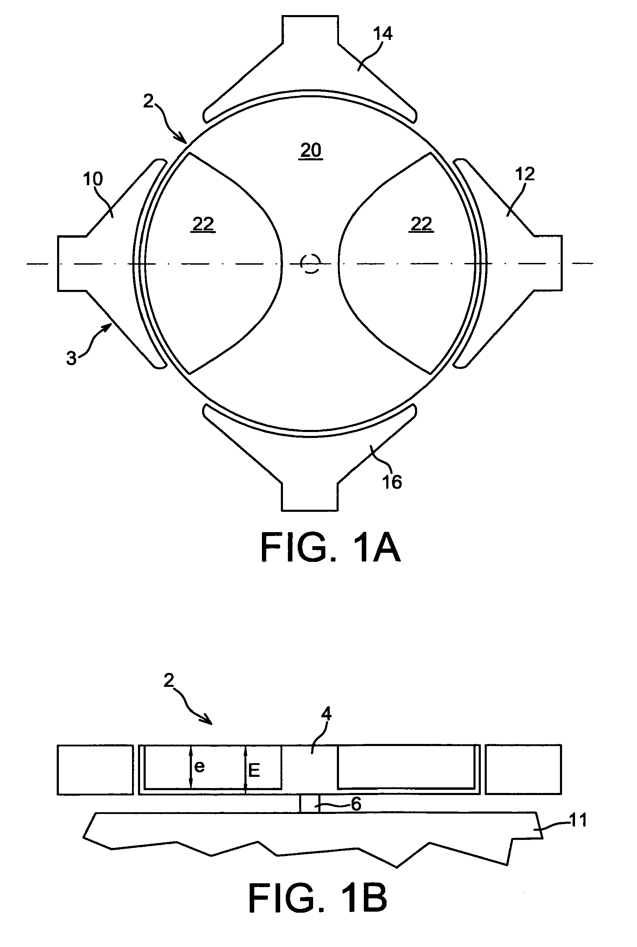

Un premier mode de réalisation de l'invention va être expliqué en liaison avec les figures 1A et 1B.

Il s'agit de l'exemple d'un résonateur de type cylindrique à transduction capacitive. Mais il peut également s'agir de résonateurs de type plaque et plus généralement de résonateurs à onde de volume.

Le composant proposé est constitué de deux parties distinctes 2, 3.

Une première partie 2 est dédiée à la résonance mécanique. Elle comprend un corps vibrant ainsi que des moyens d'ancrage 6 du corps à un substrat 11. Il s'agit d'un cylindre « composite » (constitué d'au moins deux matériaux distincts), ancré au centre d'une de ses bases par un pied cylindrique 6 de faibles dimensions.

Une deuxième partie 3, de transduction, vise à créer un signal mécanique à partir d'un signal électrique (excitation) et inversement. La détection est séparée dans le cas d'un composant à deux ports mais la détection n'est pas, dans tous les cas, nécessairement séparée de l'excitation.

Dans cette deuxième partie interviennent une ou plusieurs électrodes 10, 12 de détection ainsi qu'un moyen de transduction, capacitif dans cet exemple Il peut n'y avoir qu'une seule électrode de détection.

Une ou plusieurs électrodes d'excitation 14,16 sont également présentes. Elle permettent de générer une force électrostatique au niveau du corps vibrant qui peut ainsi, ou non, entrer en résonance mécanique.

Les électrodes sont donc dans cet exemple au nombre de quatre, et sont placées en regard de la face latérale du cylindre, à une distance angulaire relative de 90°, les deux électrodes de détection (respectivement d'excitation) étant diamétralement disposées. En variante, les même électrodes peuvent servir à la fois à l'excitation et à la détection. Dans ce cas, on pourra choisir d'en placer deux, diamétralement opposées par rapport au cylindre.

On entend par « corps vibrant du résonateur » l'élément dont on souhaite qu'il entre en résonance à une fréquence particulière.

Les ancrages 6 et les éléments qui y sont liés ne sont pas concernés par cette dénomination.

Comme on le voit sur les figures 1A et 1B, le corps vibrant 4 comporte lui - même deux parties :

- une première partie 20, en un premier matériau, par exemple en silicium monocristallin ou en nickel ou en diamant ou, plus généralement, en un matériau à module d'Young élevé (typiquement >100 Giga Pascal).
- une deuxième partie 22, en un deuxième matériau, par exemple en aluminium ou en or ou en zinc ou en magnésium ou, plus généralement, en un matériau à faible module d'Young (typiquement <100 GPa), en tout cas strictement inférieur au premier module d'Young pour le premier matériau.

Afin d'obtenir de grandes déformations sur une surface importante au niveau de la transduction de détection, le deuxième matériau est présent localement au niveau des électrodes sur une épaisseur e importante (relativement à l'épaisseur totale du corps vibrant), par exemple une épaisseur comprise entre 70 % et 100 % de l'épaisseur E du corps 4.

Ce deuxième matériau est situé au moins partiellement en face d'une électrode de détection, ou dans une cavité réalisée dans la première partie 20.

Il est placé de manière à interagir avec les électrodes 10,12 de détection.

Ce deuxième matériau est, de préférence, placé le plus près possible de la surface de transduction des électrodes 10,12 de détection. Il peut même être présent au niveau de cette surface.

Enfin, ce deuxième matériau présente de préférence un volume suffisant pour que le gain de déformation soit sensible par rapport au même corps vibrant, qui serait constitué exclusivement du matériau 1.

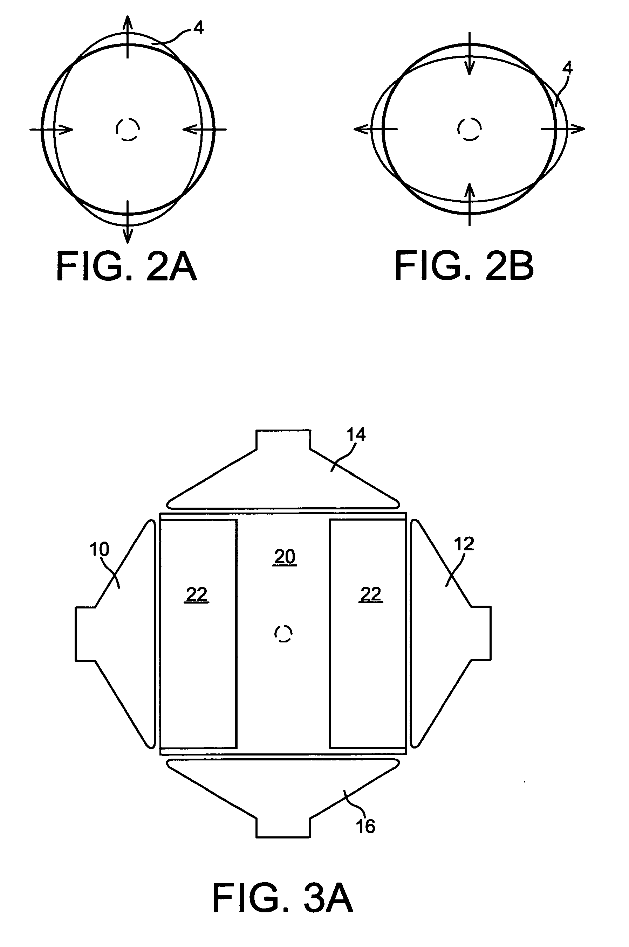

Dans le cas où le mode de vibration désiré est celui dont la déformée est représentée par la figures 2A et 2B, parfois appelé mode « Wine-Glass », comme décrit dans le document de M.A. Abdelmoneum, M.U. Demirci and T.C. Nguyen, « Stemless wine-glass-mode disk micromechanical resonators » IEEE (2003), le composant dispose généralement de quatre électrodes, deux d'excitation alternés avec deux de détection.

Le schéma de la figure 1A est un exemple de ce type de composant.

Le deuxième matériau est alors disposé au moins partiellement au niveau des électrodes de détection.

Sur les figures 2A et 2B, les flèches montrent la direction et le sens de déplacement et correspondent à l'emplacement des électrodes pour un résonateur 4 de type disque.

Lors du fonctionnement du composant, le corps vibrant est polarisé. Le signal d'entrée est transmis des électrodes d'excitation 14, 16 au corps vibrant 4 par l'intermédiaire des forces électrostatiques qui sont exercées entre eux (les électrodes 14, 16 étant fixes). Pour un signal quelconque, les déplacements du corps vibrant 4 sont très réduits et ne permettent pas la génération du signal en sortie. Lorsque le signal d'entrée possède une composante correspondant à la fréquence de résonance du corps vibrant (celle-ci dépend de la géométrie du corps vibrant, le rayon du disque par exemple), ce dernier entre en résonance mécanique. Le disque se déforme alors, avec une composante de déformation, ou notamment ou essentiellement avec une composante de déformation, dans un plan défini parallèle au substrat 11, ou défini par le corps du dispositif et les électrodes. Par exemple, il se déforme selon la représentation des figures 2A et 2B pour le mode « Wine-glass ». Il y a alors génération d'un courant dans les électrodes de détection 10, 12, qui sont fixes.

Ce courant est d'autant plus important que le déplacement du corps vibrant est important (relativement à l'entrefer) au niveau des électrodes.

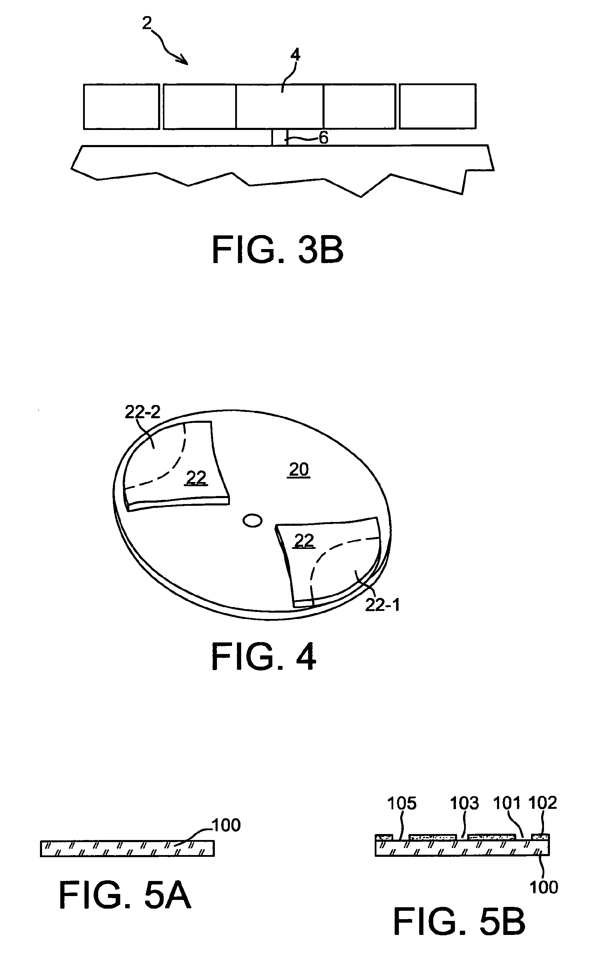

Les figures 3A et 3B représentent une variante de l'invention, avec un résonateur composite de type plaque. Dans ce mode de réalisation, la présence du matériau 22 est optimale par rapport aux électrodes de détections 10,12.

Un exemple de procédé de réalisation d'un dispositif selon l'invention va maintenant être décrit.

Un tel procédé commence par la sélection et la préparation d'une tranche de silicium 100 (figure 5A).

Sur cette tranche 100 est déposée une couche 102 de dioxyde de silicium (SiO$_2$) qui est gravée après lithographie (figure 5B). La gravure permet de dégager des ouvertures 101, 103, 105 sur le substrat 100. La couche isolante sacrificielle a une épaisseur de quelques micromètres, par exemple 2 $\mu$m.

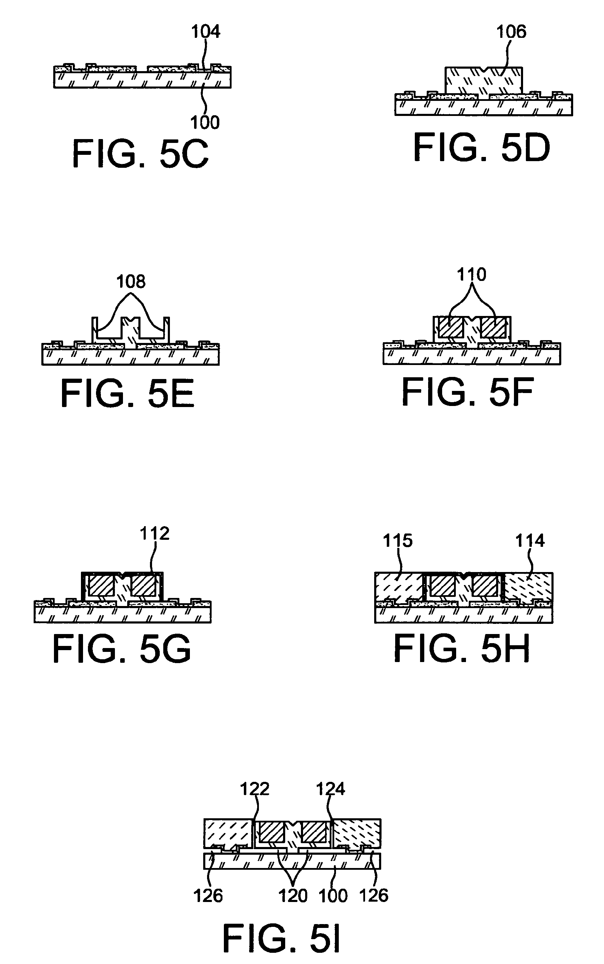

On dépose ensuite une couche de nitrure de silicium Si$_3$N$_4$ 104, qui est gravée après lithographie (figure 5C). Cette couche isolante a une épaisseur d'environ 1 $\mu$m. Elle permet de combler certaines des ouvertures 101,105 réalisées précédemment afin de permettre ultérieurement l'isolation des électrodes.

Il est ensuite procédé au dépôt d'une couche 106 de silicium, sur environ 3 $\mu$m. Cette couche est gravée, après lithographie, pour former un socle 106 (figure 5D) dans lequel des cavités 108 peuvent être gravées (figure 5E), de préférence sur une profondeur importante, par exemple comprise entre 70 % et 95 % de l'épaisseur du socle.

Il est ensuite procédé, par lithographie et gravure, à un dépôt d'aluminium 110 dans les cavités 108 (figure 5F). Il s'agit en fait du deuxième matériau du corps vibrant du résonateur (référence 22 sur les figures 1 et 3), conformément à la présente invention.

On procède ensuite au dépôt d'une couche sacrificielle 112, par exemple en dioxyde de silicium SiO$_2$ sur une épaisseur d'environ 0.1 $\mu$m (figure 5G).

Il est ensuite procédé au dépôt du matériau qui formera les électrodes, par exemple du silicium. Après dépôt, planarisation, lithographie et gravure, on obtient des électrodes 114, 115 (figure 5H).

On procède enfin à la libération de la structure par gravure de la couche sacrificielle 102 et de la couche sacrificielle 112, libérant ainsi des cavités 120, 126 entre le dispositif proprement dit et le substrat 100, et des cavités 122, 124 entre le corps vibrant et les électrodes 114, 115 (figure 5I).

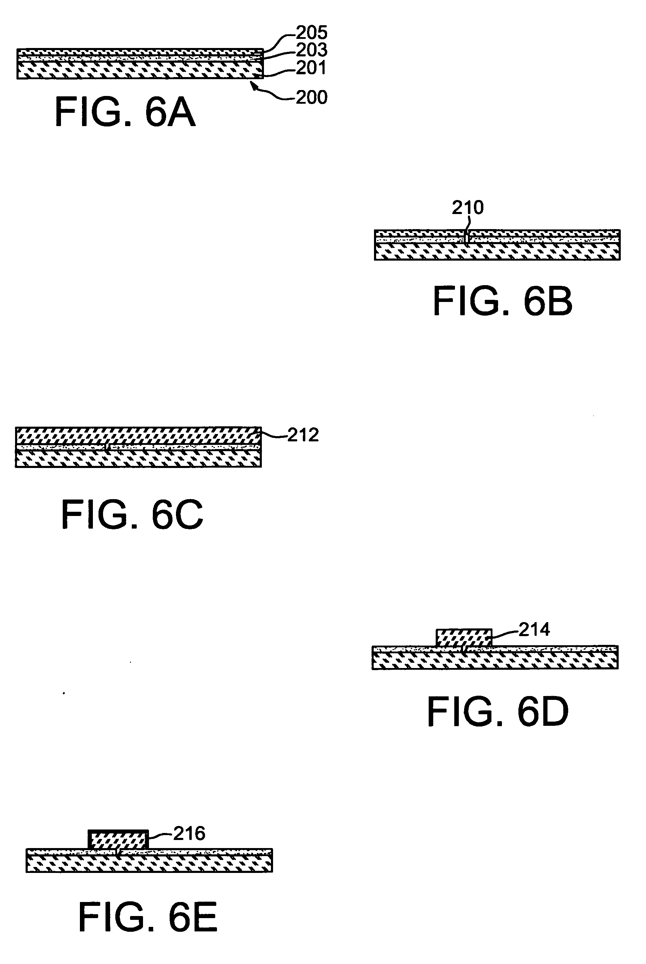

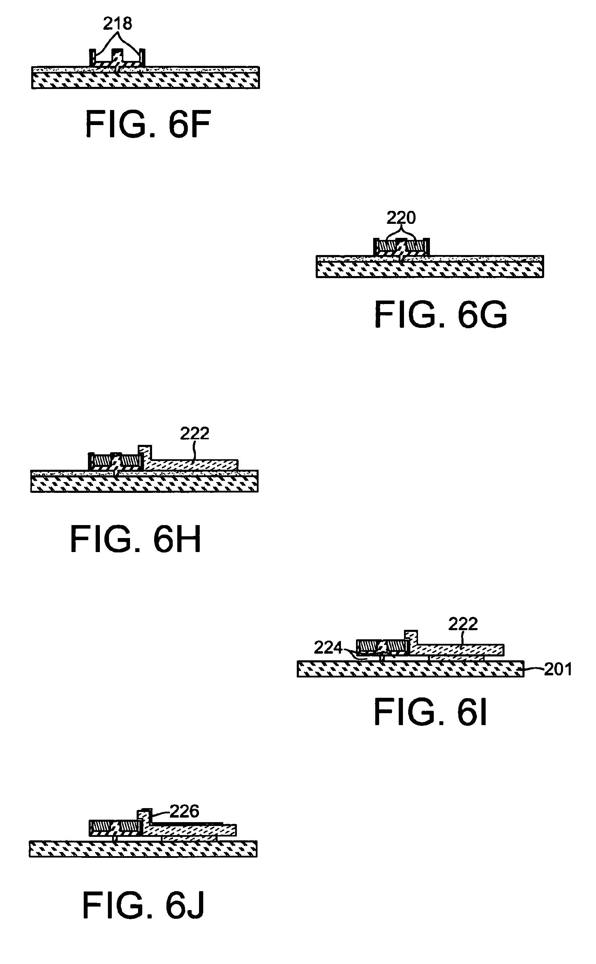

Un autre procédé de réalisation selon l'invention va être décrit en liaison avec les figures 6A-6J.

Ce procédé fait usage d'un substrat SOI 200 (silicium sur isolant) comportant un substrat 201, par exemple en silicium, une couche 203 isolante, par exemple en dioxyde de silicium SIO$_2$, dont l'épaisseur peut être d'environ 0,4 $\mu$m, et une couche de silicium 205, par exemple d'épaisseur 0,2 $\mu$m.

Une première étape de gravure est réalisée, afin de graver dans les couches 205 et 203 un motif 210, qui permettra par la suite de réaliser le pied du corps vibrant (figure 6B).

Il est ensuite procédé (figure 6C) à une étape de nettoyage de la surface du substrat, et à une croissance épitaxiale d'une couche 212 de silicium, par exemple sur une épaisseur d'environ 2,8 $\mu$m.

Cette couche est ensuite gravée, de manière à dégager le corps vibrant 21 (figure 6D).

Ce corps est oxydé de manière à former une couche 216 d'oxydation de surface (figure 6$^E$). Cette couche est par exemple réalisée par traitement thermique, elle peut avoir une épaisseur comprise entre 0,01 $\mu$m et 0,3 $\mu$m.

Des caissons 218 sont ensuite gravés dans la couche d'oxyde 216 et dans le corps 214. La profondeur de ces caissons peut être comprise entre 70 % et 100 % de l'épaisseur totale du corps 214.

Il est ensuite procédé à un dépôt et une gravure d'aluminium 220 dans les caissons 218 (figure 6G). Des électrodes, telle que l'électrode 222 (figure 6H), sont ensuite formées par dépôt, par exemple de poly-silicium dopé P++ sur une épaisseur de 2 à 3 $\mu$m.

La structure de corps vibrant est ensuite libérée par gravure de la couche sacrificielle 203 de SIO$_2$, laissant ainsi apparaître des cavités 224 entre le corps vibrant proprement dit et le substrat 201, et entre le corps vibrant et les électrodes 222 (figure 6I) .

Il est ensuite procédé à une métallisation en surface des électrodes, pour former des plots 226 (figure 6J).

Ce procédé permet d'obtenir un résonateur dont la partie correspondant à la partie 20 de la figure 1A est composée de silicium mono-cristallin, réalisé par une étape d'épitaxie.

L'ancrage du corps vibrant au substrat est alors composé du même cristal.

Ceci permet d'améliorer les caractéristiques mécaniques du corps vibrant, en réduisant les sources de pertes que sont les interfaces entre matériaux différents, notamment dans le cas où l'axe central est en silicium poly-cristallin alors que le reste du corps vibrant est en silicium mono-cristallin, ou les joints de grain. Il en découle des performances plus élevées que les dispositifs actuellement connus.

Un dispositif selon l'invention peut présenter de faibles dimensions (typiquement 50 $\mu$m*50 $\mu$m).

Un tel dispositif est en outre stable en température : ce composant est assez peu sensible aux variations de la température : l'ancrage unique 6 (central ici) limite l'apparition de contraintes par dilatation différentielle.

Les étapes de réalisations technologiques d'un tel dispositif sont en outre compatibles avec les techniques de circuits intégrés (IC).

Ce dispositif permet également d'atteindre des fréquences de résonance élevées : l'utilisation d'un premier matériau à caractéristiques mécaniques élevées permet d'obtenir des fréquences de résonances élevées (de l'ordre de la centaine de MHz) pour des dimensions de l'ordre de la dizaine de microns (et notamment pour les dimensions déjà envisagées ci-dessus, de 50 $\mu$m x 50 $\mu$m).

En outre, une amplitude de déplacement importante au niveau de la transduction, permet d'obtenir un niveau de signal élevé en sortie du composant.

Un calcul par éléments finis montre d'ailleurs un déplacement plus important des surfaces de transduction au niveau des implantation du deuxième matériau 22. La figure 4 illustre d'ailleurs la déformée d'un composant selon l'invention, les zones les plus déformées étant celle en matériau 22, et plus particulièrement les zones 22-1, 22-2 situées les plus proches des électrodes de détection.

Des simulations effectuées montrent que, pour une même fréquence de résonance (60 MHz), le déplacement maximal de la structure présenté (premier matériau : silicium, deuxième matériau : aluminium) est supérieur, d'un facteur supérieur à $10^3$, à celui d'un disque composé exclusivement de silicium.

Le courant de sortie des électrodes de mesure s'exprime selon l'équation :

$$i \;=\; -V_p \varepsilon_0 \varepsilon_r \;\; \frac{S}{(d_0 + x)^2}\frac{dx}{dt} + C\frac{dV_p}{dt}$$

où :

- $V_p$ est le tension de polarisation du corps vibrant,
- $\varepsilon_0$, $\varepsilon_r$ sont la permittivité diélectrique du vide et la permittivité relative de l'air,
- S est la surface de transduction liée à la détection,
- $d_o$+x représente l'épaisseur de l'entrefer au niveau de la surface de transduction,
- C est la valeur capacitive de la surface de détection au repos.

On peut voir qu'une grande variation dx d'entrefer (positive ou négative) permet d'obtenir de fortes variations d'intensités et donc un niveau de signal élevé.

Réciproquement, cette loi montre qu'à déplacement constant, la polarisation appliquée au corps vibrant du composant est plus faible que celle appliquée à un résonateur dont le corps vibrant est en un seul matériau. Les résonateurs recensés dans la littérature ont une tension de polarisation de quelques dizaines de volts à plus d'une centaine de volts alors que les composants selon l'invention ont des tensions de polarisation inférieures, typiquement comprises entre quelques volts et quelques dizaines de volts, par exemple entre 2 V ou 5V et 20 V ou 30 V. Ceci est un avantage important dans une perspective d'intégration d'une puce.

Les applications industrielles concernent le domaine des composants passifs pour applications RF (oscillateurs de référence , oscillateurs variables, filtres), ainsi que tous les domaines électroniques et microélectroniques utilisant des résonateurs.

**Revendications**

1. Résonateur électromécanique comportant un corps vibrant (4), au moins une électrode d'excitation (14,16) et au moins une électrode de détection (10,12), **caractérisé en ce que** le corps vibrant comporte une première partie (20) en un premier matériau, avec un premier module d'Young, et une deuxième partie (22), en un deuxième matériau, avec un deuxième module d'Young, inférieur au premier module d'Young, cette deuxième partie étant située dans une cavité du premier matériau, et au moins partiellement en face de l'électrode (10,12) de détection.

2. Résonateur selon la revendication 1, le premier module d'Young étant supérieur à 100 GPa.

3. Résonateur selon la revendication 1 ou 2, le deuxième module d'Young étant inférieur à 100 GPa.

4. Résonateur selon l'une des revendications 1 à 3 le premier matériau étant en silicium monocristallin ou en nickel ou en diamant.

5. Résonateur selon l'une des revendications 1 à 4, le deuxième matériau étant en aluminium ou en or ou en zinc ou en magnésium.

**6.** Résonateur selon l'une des revendications 1 à 5, le corps vibrant étant de forme circulaire.

**7.** Résonateur selon l'une des revendications 1 à 5, le corps vibrant étant de forme carrée.

**8.** Résonateur selon l'une des revendications 1 à 7, comportant deux électrodes d'excitation et deux électrodes de détection, disposées à 90° l'une de l'autre.

**9.** Résonateur selon l'une des revendications 1 à 7, comportant deux électrodes, chacune étant électrode d'excitation et de détection, ces deux électrodes étant disposées de manière diamétralement opposée.

**10.** Résonateur selon l'une des revendications 1 à 9, le deuxième matériau (22) étant localement présent sur une épaisseur e comprise entre 70 % et 100 % de l'épaisseur E du corps vibrant (4).

**11.** Résonateur selon l'une des revendications 1 à 10, comportant en outre un ancrage ou un pied unique (6) qui le relie à un substrat.

**12.** Procédé de réalisation d'un résonateur électromécanique, comportant un corps vibrant comportant lui-même une première partie en un premier matériau, avec un premier module d'Young, et une deuxième partie, en un deuxième matériau, avec un deuxième module d'Young, inférieur au premier module d'Young, au moins une électrode d'excitation et au moins une électrode de détection, en face de laquelle la deuxième partie du corps vibrant est au moins partiellement située, ce procédé comportant :

    - une étape de gravure d'au moins une cavité dans un socle, formé dudit premier matériau, ayant le premier module d'Young,
    - une étape de dépôt, dans ladite cavité, du deuxième matériau, dont le module d'Young, ou deuxième module d'Young, est inférieur au premier module d'Young.

**13.** Procédé selon la revendication 12, comportant en outre une étape de réalisation d'électrodes (114,115,122), en face ou en vis-à-vis du deuxième matériau (110,120).

**14.** Procédé selon la revendications 12 ou 13, comportant en outre une gravure pour libérer le résonateur d'un substrat (100,201) en ne laissant qu'un pied (6) de liaison à ce substrat.

**15.** Procédé selon l'une des revendications 12 à 14, la ou les cavités étant gravées sur une épaisseur e comprise entre 70 % et 95 % de l'épaisseur E du socle (106).

**16.** Procédé selon l'une des revendications 12 à 15, le socle (214) étant obtenu par gravure d'une couche épitaxiée (212) sur un substrat SOI (200).

**17.** Procédé selon l'une des revendications 1 à 16, le socle étant en silicium monocristallin.

**Claims**

**1.** Electromechanical resonator comprising a vibrating body (4), at least one excitation electrode (14, 16) and at least one detection electrode (10, 12), **characterized in that** the vibrating body comprises a first part (20) made of a first material with a first Young's modulus and a second part (22) made of a second material with a second Young's modulus less than the first Young's modulus, said second part being located in a cavity of the first material at least partially facing the detection electrode (10, 12).

**2.** Resonator according to claim 1, the first Young's modulus being greater than 100 GPa.

**3.** Resonator according to claim 1 or 2, the second Young's modulus being less than 100 GPa.

**4.** Resonator according to one of claims 1 to 3, the first material being made of monocrystalline silicon or nickel or diamond.

5. Resonator according to one of claims 1 to 4, the second material being made of aluminium or gold or zinc or magnesium.

6. Resonator according to one of claims 1 to 5, the vibrating body being circular.

7. Resonator according to one of claims 1 to 5, the vibrating body being square.

8. Resonator according to one of claims 1 to 7, comprising two excitation electrodes and two detection electrodes, arranged at 90° from each other.

9. Resonator according to one of claims 1 to 7, comprising two electrodes, each being an excitation and detection electrode, these two electrodes being positioned in diametrically opposite manner.

10. Resonator according to one of claims 1 to 9, the second material (22) being present locally over a thickness e of between 70% and 100% of the thickness E of the vibrating body (4).

11. Resonator according to one of claims 1 to 10, further comprising an anchor or a single base (6) connecting it to a substrate.

12. Process for making an electromechanical resonator comprising a vibrating body itself comprising a first part made of a first material with a first Young's modulus, and a second part made of a second material with a second Young's modulus less than the first Young's modulus, at least one excitation electrode and at least one detection electrode, the second part of the vibrating body at least partially facing this detection electrode, this process comprising:

- a step to etch at least one cavity in a base made of said first material with a first Young's modulus,
- a step to deposit the second material in said cavity with a second Young's modulus less than the first Young's modulus.

13. Process according to claim 12, further comprising a step to produce electrodes (114, 115, 122) facing the second material (110, 120).

14. Process according to either claim 12 or 13, further comprising an etching step to release the resonator from a substrate (100, 201) only leaving a connection base (6) to this substrate.

15. Process according to one of claims 12 to 14, the cavity (cavities) being etched over a thickness e between 70% and 95% of the thickness E of the base (106).

16. Process according to one of claims 12 to 15, the base (214) being obtained by etching an epitaxied layer (212) on an SOI substrate (200).

17. Process according to one of claims 1 to 16, the base being made of monocrystalline silicon.

**Patentansprüche**

1. Elektromechanischer Resonator mit einem Vibrationskörper (4), mindestens einer Erregerelektrode (14,16) und mindestens einer Detektionselektrode (10,12),
**dadurch gekennzeichnet, dass** der Vibrationskörper einen ersten Teil (20) aus einem ersten Material mit einem ersten Young-Modul umfasst sowie einen zweiten Teil (22) aus einem zweiten Material mit einem zweiten Young-Modul, der kleiner ist als der erste Young-Modul, wobei dieser zweite Teil sich in einem Hohlraum des ersten Materials befindet und wenigstens partiell der Detektionselektrode (10,12) gegenübersteht.

2. Resonator nach Anspruch 1, wobei der erste Young-Modul größer als 100 GPa ist.

3. Resonator nach Anspruch 1, wobei der erste Young-Modul kleiner als 100 GPa ist.

4. Resonator nach einem der Ansprüche 1 bis 3, wobei das erste Material aus monokristallinem Silicium oder aus Nickel oder aus Diamant ist.

**5.** Resonator nach einem der Ansprüche 1 bis 4, wobei das zweite Material aus Aluminium oder aus Gold oder aus Zink oder aus Magnesium ist.

**6.** Resonator nach einem der Ansprüche 1 bis 5, wobei der Vibrationskörper von runder Form ist.

**7.** Resonator nach einem der Ansprüche 1 bis 5, wobei der Vibrationskörper von quadratischer Form ist.

**8.** Resonator nach einem der Ansprüche 1 bis 7 mit zwei Erregerelektroden und zwei Detektionselektroden, jeweils um 90° gegeneinander versetzt.

**9.** Resonator nach einem der Ansprüche 1 bis 7 mit zwei Elektroden, von denen jede Erreger- und Detektionselektrode ist, wobei diese beiden Elektroden sich diametral gegenüberstehen.

**10.** Resonator nach einem der Ansprüche 1 bis 9, wobei das zweite Material (22) lokal eine Dicke e aufweist, die zwischen 70 und 100 % der Dicke E des Vibrationskörpers (4) beträgt.

**11.** Resonator nach einem der Ansprüche 1 bis 10 mit außerdem einer Verankerung oder einem einzigen Fuß (6) zur Verbindung mit einem Substrat.

**12.** Verfahren zur Herstellung eines elektromechanischen Resonators mit einem Vibrationskörper, der selbst einen ersten Teil aus einem ersten Material mit einem ersten Young-Modul umfasst und einen zweiten Teil aus einem zweiten Material mit einem zweiten Young-Modul, der kleiner ist als der erste Young-Modul, sowie mindestens eine Erregerelektrode und mindestens eine Detektionselektrode umfasst, welcher der zweite Teil des Vibrationskörpers wenigstens partiell gegenübersteht, wobei dieses Verfahren umfasst:

- einen Schritt, in dem man mindestens einen Hohlraum in einen aus dem ersten Material mit dem ersten Young-Modul gebildeten Sockel ätzt,
- einen Schritt des Abscheidens des zweiten Materials mit dem Young-Modul oder zweiten Young-Modul, der kleiner ist als der erste Young-Modul.

**13.** Verfahren nach Anspruch 12 mit außerdem einem Schritt zur Herstellung von dem zweiten Material (110,120) gegenüberstehenden Elektroden (114,115,122).

**14.** Verfahren nach Anspruch 12 oder 13 mit außerdem einer Ätzung zur Befreiung des Resonators von einem Substrat (100,201), wobei man einen Fuß (6), der ihn mit dem Substrat verbindet, stehen lässt.

**15.** Verfahren nach einem der Ansprüche 12 bis 14, wobei der Hohlraum oder die Hohlräume über eine Dicke e geätzt werden, die zwischen 70 % und 95 % der Dicke E des Sockels (106) beträgt.

**16.** Verfahren nach einem der Ansprüche 12 bis 15, wobei man den Sockel (214) herstellt, indem man eine Epitaxieschicht (212) auf einem SOI-Substrat (200) ätzt.

**17.** Verfahren nach einem der Ansprüche 1 bis 16, wobei der Sockel aus monokristallinem Silicium ist.

FIG. 1A

FIG. 1B

FIG. 2A

FIG. 2B

FIG. 3A

## FIG. 3B

## FIG. 4

## FIG. 5A

## FIG. 5B

104

100

FIG. 5C

106

FIG. 5D

108

FIG. 5E

110

FIG. 5F

112

FIG. 5G

115          114

FIG. 5H

122          124

126        120  100  126

FIG. 5I

205
203
201
200

## FIG. 6A

210

## FIG. 6B

212

## FIG. 6C

214

## FIG. 6D

216

## FIG. 6E

218

FIG. 6F

220

FIG. 6G

222

FIG. 6H

222

224

201

FIG. 6I

226

FIG. 6J

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2002105393 A

**Littérature non-brevet citée dans la description**

- **J.WANG et al.** 1,14 GHZ self-aligned vibrating micromechanical disk resonator. *IEEE Radio Frequency Integrated Circuits Symposium,* 2003
- **V. KAAJAKARI ; T.MATTILA ; A.OJA ; J.KIIHAMAKI ; H.KOSKENVUORI ; P.RANTAKARI ; I.TITTONEN ; H.SEPPA.** Square-extensional mode single-crystal silicon micromechanical RF-resonators. *IEEE Transducers,* 2003, vol. 03
- **M.A. ABDELMONEUM ; M.U. DEMIRCI ; T.C. NGUYEN.** Stemless wine-glass-mode disk micromechanical resonators. *IEEE,* 2003